Europäisches Patentamt

European Patent Office

Office européen des brevets

(11) Publication number: **0 282 012**
**A2**

## EUROPEAN PATENT APPLICATION

(21) Application number: **88103643.8**

(22) Date of filing: **08.03.88**

(51) Int. Cl.⁴: **H01L 23/48** , H01L 29/66 ,
H01L 27/18

(30) Priority: **09.03.87 JP 53724/87**
**09.03.87 JP 53725/87**

(43) Date of publication of application:
**14.09.88 Bulletin 88/37**

(84) Designated Contracting States:
**DE FR GB**

(71) Applicant: **SEMICONDUCTOR ENERGY
LABORATORY CO., LTD.
398 Hase
Atsugi-shi Kanagawa-ken, 243(JP)**

(72) Inventor: **Yamazaki, Shunpei
21-21, Kitakarasuyama 7-chome
Setagawa-ku, Tokyo, 157(JP)**

(74) Representative: **Patentanwälte Grünecker,
Kinkeldey, Stockmair & Partner
Maximilianstrasse 58
D-8000 München 22(DE)**

(54) Superconducting semiconductor device.

(57) The present invention relates to a manufacturing method for a semiconductor device using a superconducting ceramic material, and more particularly to a manufacturing method for a semiconductor device wherein one part or all of the connecting wiring in the semiconductor device is formed from a superconducting ceramic material and wherein the semiconductor device can be activated at a low temperature such as 70 °K to 100 °K, or ideally 77 °K.

The semiconductor of the present invention comprises a semiconductor substrate with at least one element provided within this semiconductor substrate and a superconducting material with zero electrical resistance formed on this substrate or on the upper surface of the insulating film or on the conductor with the superconducting material being selectively etched and patterning being performed on the substrate.

EP 0 282 012 A2

# FIG.I(A)

## SUPERCONDUCTING SEMICONDUCTOR DEVICE

### [FIELD OF THE INVENTION]

The present invention relates to a manufacturing method for a semiconductor device using a superconducting ceramic material, and more particularly to a manufacturing method for a semiconductor device wherein one part or all of the connecting wiring in the semiconductor device is formed from a superconducting ceramic material and wherein the semiconductor device can be activated at a low temperature such as 70 °K to 100 °K, or ideally 77 °K.

### [Background of the invention]

Conventionally, a wire rod of a Nb-Ge metallic material (for example, $Nb_3Ge$) and the like is used as a superconducting material. It is limited to such uses as for a superconducting magnet.

In addition, in recent years ceramic materials which exhibit superconducting properties are known. However, these are also in ingot form and as yet there has been no development of superconducting materials in thin film form.

Methods by which thin film is produced by patterning, using photolithographic techniques, and the use of this thin film as one part of the connecting wiring of a semiconductor device are also completely unknown.

On the other hand, semicondector devices provided with a plurality of the elements containing semiconductor integrated circuits within the same substrate are known. However, there are absolutely no cases known of trials for activation of these semiconductor devices at low temperatures such as the temperature of liquid nitrogen (77°K).

The development of more and more refined semiconductor integrated circuits with high speed action has in recent years become a necessity. Also, along with this refinement a drop in reliability from the heat generated in the semiconductor element and also a reduction in activation speed in the heated parts has become a problem.

For this reason, if a semiconductor element is activated at the temperature of liquid nitrogen, the mobility of the electrons and holes in that element can be increased 3 or 4 times compared with the mobility at room temperature, and the frequency characteristics of the element can also be improved.

Also, because there is cooling from the liquid nitrogen, localized heating can be prevented from occurring, and it can be presumed that the product will be superior, with increased reliability.

However, when the element is activated at such extremely low temperatures, conversely, the electrical resistance of the metallic load wire is increased by a factor of some tens, and the retarded frequency characteristics of the load wire becomes a problem.

### [SUMMARY OF THE INVENTION]

An object of the present invention is to provide, with due consideration to the drawbacks of such conventional devices, a semiconductor device having a connecting wiring provided by means of a ceramic material which exhibits superconductivity at extremely low temperatures (20°K to 100°K, and preferably 77°K or higher).

Another object of the present invention is to provide a semiconductor device which operates in an electrically stable condition at a low temperature.

Another object of the present invention is to provide a semiconductor device which has a connecting wiring of a superconductive material to connect semiconductor elements in the device.

Another object of the present invention is to provide a semiconductor device which has a connecting wiring of a superconductive material to connect a semiconductor element and input and/or output terminals in the device.

The semiconductor of the present invention comprised of a semiconductor substrate, at least one element provided within this semiconductor substrate and a superconducting material with zero electrical resistance formed on this substrate or on the upper surface of the insulating film or on the conductor with the superconducting material being selectively etched and patterning being performed on the substrate.

### [BRIEF DESCRIPTION OF THE DRAWINGS]

These and other objects, features, and advatages of the present invention will become more apparent from the following description of the preferred embodiments taken in conjunction with the accompanying drawings, in which:-

FIGS,1(A),(B),(C), and (D) show the steps in the production of an embodiment of the superconducting semiconductor device of the present invention.

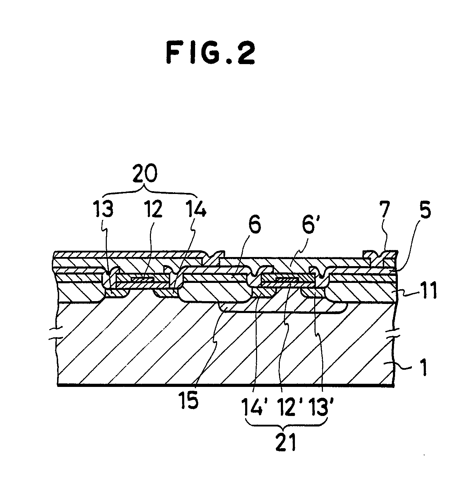

FIG.2 is an enlarged cross sectional view of another embodiment of the superconducting semiconductor device of the present invention.

[DETAILED DESCRIPTION OF THE PREFERRED EMBODIMENTS]

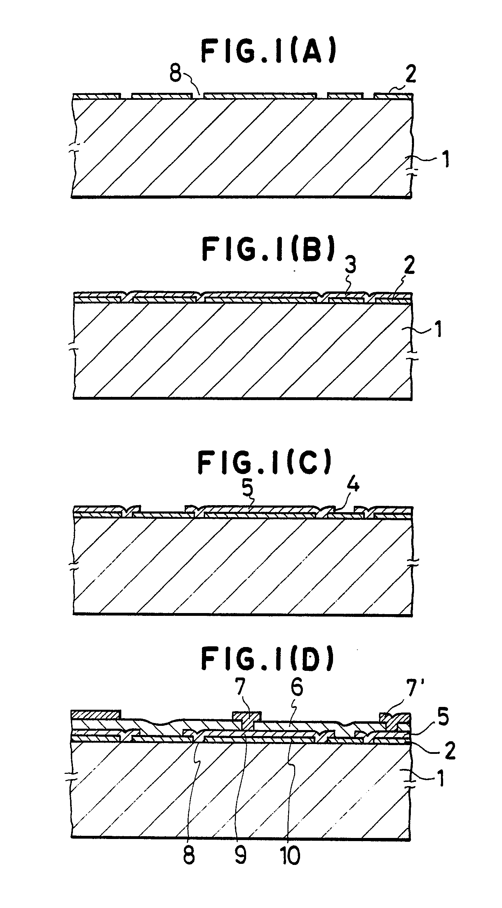

FIG. 1 shows the steps in the production of an embodiment of the superconducting semiconductor device of the present invention.

The semiconductor of the present invention comprised of a semiconductor substrate which is desirebly heat resistant, for example, a single crystalline silicon semiconductor substrate and a plurality of elements provided within this semiconductor substrate such as an insulated gate field effect transistor (FET), bipolar transistor, static electricity induction transistor(SIT), resistance, and capacitor. Then, a superconducting material with zero electrical resistance is formed on this substrate or on the upper surface of the insulating film or on the conductor. This superconducting material is selectively etched, and patterning is performed by photolithographic techniques. In addition, the crystalline structure of the ceramic material is altered by heat annealing at 500°C to 1000°C, particularly, in an oxidizing atmosphere either before or after this step, so that superconductivity is exhibited at extreamely low temperatures. By repeating this process once or several times, one layer or several layers of connecting wiring are formed of a material with zero electrical resistance.

Now referring to FIG.1(A), an insulating film 2 is formed on a silicon semiconductor substrate 1 and an opening 8 is formed in the insulating film 2 by a photolithography technique.

Inside the semiconductor substrate 1, there are previously provided an insulated gate field effect transistor (IGFET), an active element such as a bipolar transistor or a resistance, and a passive element such as a capacitor. Then a contact section for an electrode of the active element or the passive element is provided to correspond to the opening 8.

In FIG.1(B), a material which exhibits superconducting capabilities is formed on the upper surface of these elements in the form of a thin film. The thin film is formed by the sputtering method in this embodiment. However, the screen printing method, vacuum evaporating method, or chemical vapor deposition method (CVD method) may also be used. However, the sputtering method used here is suitable for mass production, and easily produces a ceramic thin film which is heat resistant.

A representative superconducting material used in the present invention is an oxidized ceramic using elements in Gruop IIIa and IIa of the Periodic Table, and copper.

The superconducting material of the present invention can be generally represented as $(A_{1-x}B_x)_yCu_zO_w$, where $x = 0.3$ to 1, $y = 2.0$ to 4.0 or, preferably, 2.5 to 3.5, $z = 1.0$ to 4.0 or, preferably, 1.5 to 3.5, and $w = 4.0$ to 10.0 or, preferably, 6 to 8. A is one type or several types of elements from among those selected from the yttrium group and those selected from the other lanthanides. The yttrium group is defined as the group containing Y(yttrium), Gd(gadolinium), Yb(ytterbium), Eu(europium), Tb(terbium), Dy(dysprosium),Ho(holmium), Er(erbium), Tm(thulium), Lu(lutetium), Sc(scandium), and other lanthanides(Physics and Chemistry Dictionary, published by Iwanami, April, 1963)

The superconducting ceramic material of the present invention can be generally represented as $(A_{1-x}B_x)_yCu_zO_w$,where $x = 0.3$ to 1, $y = 2.0$ to 4.0 or, preferably 2.5 to 3.5, $z = 1.0$ to 4.0 or, preferably 1.5 to 3.5, and $w = 4.0$ to 10.0 or, preferably 6 to 8. A is one type of element selected from the elements in Group Vb in the Periodeic table, consisting of Bi(bismuth), Sb(antimony), As(arsenic), and P(phosphorous).

In addition, B is at least two types of elements, B1,B2---Bn, for example B1,B2, selected from among Ba(barium), Sr(strontium), Ca(calcium), and Mg(magnesium).

In the sputtering device, the composition $(Y_{1-x}Ba_x)$ Cu $O_y$ is used as a target, where $x = 0.01$ to 0.3, and ideally is 0.05 to 0.1, $y = 2.5$ to 3.0. When $y = 2.5$, a Brawn Mirer Wright structure is adopted.

In order that the target has a critical temperature (Tc) at 77 °K or greater, the target may have a composition of $y = 2.5$ or close to that value, and also x at 0.05 to 0.1 at the time when the target is produced.

Sputtering for this embodiment is carried out at a substrate temperature of 450°C, in an argon atmosphere, and at a frequency of 50Hz and output of 100W. The thin film of ceramic material in this case is 0.2μm to 2μm in thickness, for example, a thickness of 1μm. The ceramic material is then annealed under oxygen at 700°C for 10 hours. After that, it is possible to create the superconducting thin film at Tc = 80°K, which is a suitable temperature for growing crystals. The resistance begins to drop below 80°K, and, experimentally, the resistance is practically zero at 32°K.

After this, the prescribed patterning is carried out on the thin film using photolithography techniques. In this way, the electrodes and leads for the connecting wiring containing the connections for the electrode of the elements and the input and output terminals are photoresist coated for the final configuration. Selective removal or etching is performed with acid, for example, sulphuric or nitric acid to obtain the semiconductor device of FIG.1-

(C).

This patterning can be carried out after the formation of the superconducting film, followed by heat annealing, so that only the patterned connecting operating section can be selectively crystallized.

In this case, because the crystal sizes are small in the initial status, a smaller pattern is possible in the connecting wiring.

FIG.1(D) shows the required multilayered wiring formed after the above steps. In particular, the metal has a better connecting property than the ceramic superconductor to connect the outside leads to the semiconductor device. For this reason, the insulating body 6 between the layers is formed of oxidized silicon, polyimide resin (PIQ), and the patterns 7,7' are formed of aluminum.

Specifically, in the present invention, the one layer or multiple layers of the connecting wiring of the elements are formed from the superconducting material. In addition, the electrode which is drawn outside is provided with a metal pad for better bonding property. Of course, the pad section may also be made of the superconducting material if the bonding property of the material with the outside electrode can be improved.

FIG. 2 shows another embodiment of the present invention, specifically, a C/MOS (complementary IGFET) section only.

The section has a silicon semiconductor substrate 1 with adequate durability from annealing. Further, a P-type well 15 is buried within the substrate, and silicon oxide 11 is provided. One IGFET 20 is provided with a gate electrode 12, a source 13, and a drain 14 as a P-channel IGFET. Another IGFET 21 is provided with a gate electrode 12', a source 13', and a drain 14', as an N-channel IGFET. The gate electrodes 12,12' are plycrystalline silicon, and the wiring connections between the gate electrodes 12,12' and the other wirings 5,7 are formed of the superconducting material as in Embodiment 1.

This superconducting material is made by the CVD method. In the case where no damage is imparted to the lower substrate, the gate electrode may also be formed of the superconducting material.

By means of the present invention, forming semiconductor devices during cooling at a low temperature rather than at room temperature can be put to practical use for the first time in the world.

When this kind of semiconductor element is cooled to the temperature of liquid nitrogen, the mobility of the elements or the holes can be increased 3 or 4 times. In addition, it becomes possible to reduce the electrical resistance of the lead wires and electrodes to zero. For this reason, extremely high speed action becomes possible.

Also, heat, generated from the action in the semiconductor element, is cooled by the liquid nitrogen, so that high reliability is possible in the semiconductor element.

The frequency characteristics especially can be improved by cooling a semiconductor. In metal conductors, on the other hand, the resistance, conversely, is increased at a low temperature. This drawback is eliminated by using a ceramic superconducting material as the conductor at low temperature can improve the electrical conductivity of the semiconductor device.

For this reason, the development of the technical concept of the present invention has made it possible to apply a 16M to 1G bit ULSI and the like in practice.

In the present invention, the semiconductor need not be silicon, but may be a semiconductor compound of GaAs and the like may be obtained by heteroepitaxial growth on a silicon semiconductor for use as a semiconductor film, whereby ultra high speed action can be induced. In this case, however, it is necessary to take steps to lower the annealing temperature so that the semiconductor substrate does not deteriorate during annealing.

The superconducting ceramic material for use in accordance with the present invention also may be prepared consistent with the stoichiometric formulae $(A_{1-x}B_x)_y Cu_z O_w$, where A is one or more elements of Group IIIa of the Periodic Table, e.g., the rare earth elements, B is one or more elements of Group IIa of the Periodic Table, e.g., the alkaline earth metals including beryllium and magnesium, and $x = 0$ to 1; $y = 2.0$ to 4.0, preferably 2.5 to 3.5; $z = 1.0$ to 4.0, preferably 1.5 to 3.5; and $w = 4.0$ to 10.0, preferably 6.0 to 8.0. Also, superconducting ceramics for use in accordance with the present invention may be prepared consistent with the stoichiometric formulae $(A_{1-x}B_x)_y Cu_z O_w$, where A is one or more elements of Group IVb of the Periodic Table such as Bi,Sb,and As. B is one or more elements of Group IIa of the Periodic Table, e.g., the alkaline earth metals including beryllium and magnesium, and $x = 0$ to 1; $y = 2.0$ to 4.0, preferably 2.5 to 3.5; $z = 1.0$ to 4.0, preferably 1.5 to 3.5; and $w = 4.0$ to 10.0, preferably 6.0 to 8.0. One example of the former formulae is $YBa_2Cu_3O_x (x = 6$ to 8), and one example of the latter formulae is $BiCaSrCuOx$ (the number of x can be substantially smaller than the oxygen amount of the former composition.)

## Claims

1. A superconducting semiconductor device comprising a semiconductor substrate, at least one semiconductor element provided within the substrate, and a connecting wiring provided on the substrate and formed from a superconducting material.

2. The superconducting semiconductor device of claim 1, wherein the connecting wiring is used to connect the semiconductor element to at least one of input and output terminals for external electrical signals.

3. The superconducting semiconductor device of claim 1, wherein the connecting wiring is used to connect one semiconductor element to another.

4. The superconducting semiconductor device of claim 1, wherein the superconducting material is made of a ceramic material.

5. The superconducting semiconductor device of claim 1, wherein the semiconductor substrate is a single crystalline silicon semiconductor.

6. The superconducting semiconductor device of claim 1, wherein a plurality of semiconductor elements are formed in a region of the substrate having a III-V compound semiconductor.

7. The superconducting semiconductor device of claim 4, wherein the ceramic material includes copper and oxygen.

8. A method of producing a superconducting semiconductor device comprising the steps of providing a semiconductor substrate, providing at least one semiconductor element within the substrate, and providing a connecting wiring of a superconducting material on the substrate.

# FIG.I(A)

8    2
1

# FIG.I(B)

3    2
1

# FIG.I(C)

5    4

# FIG.I(D)

7    6    7'
5
2
1

8    9    10

# FIG.2